# EUROPÄISCHE PATENTANMELDUNG

(11) **EP 0 617 512 A2**
(43) Veröffentlichungstag der Anmeldung: **28.09.1994**
(21) Anmeldenummer: 94103613.9
(22) Anmeldetag: 09.03.1994
(51) Int. Cl.: H03K 17/16, H03K 17/04

(54) **Aktiver Gate-Widerstand**

(30) Priorität: 22.03.1993 DE 4309164
(71) Anmelder: SIEMENS AKTIENGESELLSCHAFT, D-80333 München (DE)
(72) Erfinder: Fischer, Gerhard, Dipl.-Ing. (FH), D-91052 Erlangen (DE)

(57) **Zusammenfassung**

Die Erfindung bezieht sich auf ein Verfahren und eine Vorrichtung (46) zur Steuerung des Spannungsverlaufes der Steuerspannung (u_{Gs}) während eines Einschaltvorgangs (t_{E}) eines mittels eines elektrischen Feldes gesteuerten abschaltbaren Leistungshalbleiters (30). Erfindungsgemäß wird der Spannungsverlauf der Steuerspannung (u_{Gs}) in Abhängigkeit des Potentialverlaufs an der Steuerelektrode (G) des Leistungshalbleiters (30) derart gesteuert, daß zu Beginn der Ansteuertotzeit (tp) des Einschaltvorgangs (t_{E}) der Anstieg (dup/dt) der Steuerspannung (uGS) gegenüber dem Anstieg (dur/dt) während der Anstiegszeit (tr) sehr viel größer ist, wobei in Abhängigkeit des Potentialverlaufs der Steuerspannung (uGS) zwischen diesen Anstiegen (dup/dt, dur/dt) gesteuert umgeschaltet wird. Somit wird mittels des aktiven Gate-Widerstands (46) im Havariefall der Diodenabriß automatisch beherrscht, so daß keine unzulässige Drain-Source-Spannung auftritt, und im Normalbetrieb die Einschaltzeit nicht unnötig verlängert wird.

## Beschreibung

Die Erfindung bezieht sich auf ein Verfahren und eine Vorrichtung zur Steuerung des Spannungsverlaufes der Steuerspannung während eines Einschaltvorganges eines mittels eines elektrischen Feldes gesteuerten abschaltbaren Leistungshalbleiters.

Aus dem Aufsatz "Anwendung des Dual-Thyristor-Prinzips in HF-Speisequellen für die Induktionserwärmung", abgedruckt in der DE-Zeitschrift "Elektrowärme International", 49 (1991) B3-August, Seiten B118-B123, ist ein MOSFET-Umrichter bekannt, der nach dem Dual-Thyristor-Prinzip im Frequenzbereich von 270 kHz bis etwa 425 kHz mit hohem Wirkungsgrad arbeitet. Wirkungsgrad, Betriebsverhalten und Komplexität leistungselektronischer Schaltungen werden nicht nur durch den Leistungshalbleiter-Schalter, sondern meist auch durch das dynamische Verhalten der Leistungsdioden bestimmt. Das nicht ideale Ausschaltverhalten der Leistungsdioden führt zu einer erheblichen Beanspruchung des Leistungshalbleiter-Schalters, beispielsweise ein Transistor, was sich nachteilig auf Ausgangsfrequenz und Wirkungsgrad auswirkt. Kennzeichen für Dual-Thyristor-Wechselrichter sind Schalter, die je einen Transistor mit Gegendiode (auch Inversdiode genannt) und Entlastungskondensator beinhalten. Charakteristisch für diesen Wechselrichter ist die Kommutierungsfolge Gegendiode-Transistor, wodurch der Einsatz einer Verriegelungseinrichtung ermöglicht wird, die erst dann das Einschaltsignal für den Transistor freigibt, wenn die Transistorspannung bereits einen kleinen Wert erreicht hat. Vorteilhafte Eigenschaften sind:
- günstige Kommutierungsreihenfolge, woraus geringe Forderungen an die Ausschalteigenschaften bauelementeinterner bzw. diskreter Gegendioden resultieren und
- in der Trennung von Inversleitdauer und du/dt-Bean-spruchung (z.B. Reduzierung der du/dt-Empfindlichkeit des MOSFETs).

Außer der Einschränkung, daß in Dual-Thyristor-Speisequellen nur ausschaltbare Leistunghalbleiter-Bauelemente eingesetzt werden können, muß die Lastanordnung immer induktiven Charakter besitzen, da sonst der Wechselrichter blockiert.

Das Dual-Thyristor-Prinzip ermöglicht den Einsatz von Leistungs-MOSFETs, wobei die in den meisten Fällen dynamisch ungünstige MOSFET-Inversdiode als Gegendiode des Schalters verwendet wird.

Aus dem Hauptanwendungsgebiet der induktiven Erwärmung, wie das Schmelzen von Metallen, das Erwärmen von metallischen Rohlingen für einen nachfolgenden Schmiedeprozeß oder das Härten von Stahl, stellt das induktive Härten in thermischphysikalischer Hinsicht besonders hohe Anforderungen an die Energiequelle.

Das Induktionshärten ist im allgemeinen ein Oberflächenhärten und wird daher Randschichthärten genannt. Der zu härtende Werkstoff wird dem magnetischen Wechselfeld eines stromdurchflossenen Leiters ausgesetzt. Dieser Leiter, auch Induktor genannt, ist entsprechend der Geometrie des Werkstücks und des angestrebten Erwärmungsbildes geformt. Der Induktor unterliegt vielfach einem deutlichen Verschleiß durch hohe thermische Belastung, magnetische Kräfte, Kavitation durch das Kühlwasser, chemische und elektrochemische Erosionen und anderes mehr.

Je nach dem Schlankheitsgrad des Induktors und der Höhe der zu übertragenden Leistung kann es zu einem mehr oder weniger häufigen Induktorversagen kommen. Dieser unvermeidbare Havariefall stellt sich in Bezug auf die Energiequelle als Lastkurzschluß oder als Lastabwurf dar. Dabei sollten keine Bauelemente der Speisequelle Schaden nehmen, die der Frequenzumformung dienen. Bleibt der Schaden auf den zerstörten Induktor beschränkt, so spricht man von einer havariefesten Energiequelle. Für das Induktionshärten ist das ein wichtiges Gütekriterium, weil ein längerer Fertigungsstillstand am schwierigsten zu überbrücken ist.

Im Aufsatz "Senderöhre, Thyristor oder MOSFETs im Frequenzwandler für das induktive Randschichthärten und ihr Einfluß auf die Anwendungstechnik", abgedruckt in der DE-Zeitschrift "Elektrowärme International", 47 (1989), B4-August, Seiten B192-B201, werden verschiedene Bauformen von Frequenzwandlern hinsichtlich ihrer Vor- und Nachteile als Energiequellen für das induktive Randschichthärten untersucht. Dabei wurde festgestellt, daß der Havariefall - Induktorbruch oder Induktorkurzschluß - beim Umrichter mit Power-MOS-Elementen am schwierigsten zu beherrschen ist. Die Ursachen sind die beiden strikt einzuhaltenden Parameter, höchstzulässige Drain/Source-Spannung und höchstzulässige Gate/Source-Spannung. Selbst kurzzeitiges Überschreiten dieser Größen für 1 bis 2 ns hat den Ausfall des Bauelementes zur Folge.

Da im Gegensatz zu Thyristoren bei Transistoren das Kommutierungsproblem nicht besteht, sind in Verbindung mit den parasitären Dioden sowohl induktive wie auch kapazitive Phasenverschiebungen am Wechselrichter möglich. Bei induktiver Phasenverschiebung beginnt die Stromleitung mit einem Diodenstrom, bei kapazitiver Phasenverschiebung endet sie mit einem Diodenstrom. Die Tatsache, daß Diodenströme auftreten können, rechtfertigt den Einsatz von Leistungs-MOSFETs, insbesondere von FREDFETs.

Bei Induktorkurzschlüssen können gefährlich hohe Spannungsspitzen auftreten. Es ist schwer, solche Spannungsspitzen zu dämpfen oder zu absorbieren, da ihr Energieinhalt sehr hoch sein kann. Energieabsorbierende Elemente zum Schutze der Transistoren, sei es in aktiver oder passiver Bauart, erweisen sich in Anbetracht des hohen Energieinhaltes und des raschen Anstieges der Transienten als wenig wirksam. Auch das Einleiten von Gegenmaßnahmen ist schwierig, da die Zeit für das Erkennen von Havariefällen und Aktivieren von Schutzmaßnahmen sehr kurz ist. Im mittleren Frequenzbereich zwischen 30 und 80 kHz zeigen sich die Havariefälle weniger kritisch als bei 200 bis 250 kHz, da die Chancen für das Einleiten von Gegenmaßnahmen günstiger sind.

Im zuletzt genannten Aufsatz wird festgestellt, daß eine Verbesserung dieses Problems zu erwarten ist, wenn in den Modulen MOSFETs verwendet werden, deren antiparallele Dioden Avalanche-Charakter haben. Weiterhin können ein oder mehrere schnelle bipolare Z-Dioden, die im Gehäuse des Moduls eingebaut sind, die Gate/Source-Strecke vor Rückwirkungen über die Gate/Drain-Kapazität schützen.

Aus dem Aufsatz "Solid State RF Generators For Induction Heating Applications", abgedruckt in "IEEE IAS", 1982, Conference Record 1982, Seiten 939 bis 944, ist eine weitere Maßnahme bekannt, mit der das dargestellte Problem gelöst wird. Die Ansteuerschaltung jedes MOSFETs enthält für den Einschaltvorgang des Leistungsschalters einen wesentlich größeren Gate-Widerstand als für den Ausschaltvorgang. Diese Vergrößerung des Gate-Widerstandes, die nur für den Einschaltvorgang wirksam ist, wird dadurch erreicht, daß ein Widerstand mit einer parallelen Diode versehen ist, die beim Ausschaltvorgang diesen Widerstand kurzschließt. Mittels der Vergroßerung des Gate-Widerstandes wird erreicht, daß das Gate des MOSFETs sich langsamer lädt und damit das MOSFET langsamer durchschaltet. Damit ergibt sich eine dynamische Gegenkopplung vom Drain zum Gate des MOSFET, das bei hohen du/dt wieder einschaltet. Allerdings steigt auch die Ansteuertotzeit mit an.

Der Erfindung liegt nun die Aufgabe zugrunde, ein Verfahren und eine Vorrichtung anzugeben, mit der das bereits erläuterte Problem auf einfache Art und Weise gelöst werden soll, ohne dabei Nachteile in Kauf nehmen zu müssen.

Diese Aufgabe wird erfindungsgemäß dadurch gelöst, daß der Spannungsverlauf der Steuerspannung während eines Einschaltvorganges eines mittels eines elektrischen Feldes gesteuerten abschaltbaren Leistungshalbleiters in Abhängigkeit des Potentialverlaufs an seiner Steuerelektrode derart gesteuert wird, daß zu Beginn der Ansteuertotzeit des Einschaltvorgangs der Anstieg gegenüber dem Anstieg während der Anstiegszeit des Einschaltvorgangs sehr viel größer ist, wobei in Abhängigkeit des Potentialverlaufs an der Steuerelektrode des Leistungshalbleiters zwischen diesen beiden Anstiegen gesteuert umgeschaltet wird. Dadurch wird der Drain-Source-Kanal eines Leistungs-MOSFETs in einem Halbbrückenzweig eines HF-Umrichters so langsam durchgeschaltet, daß das Abrißverhalten der abkommutierten Diode deutlich verbessert wird, zugleich aber die Ansteuertotzeit nicht wesentlich erhöht wird. Somit sind Havariefälle selbst bei hohen bis sehr hohen Frequenzen automatisch beherrschbar, ohne derartige Havariefälle erkennen zu müssen.

Zur Realisierung dieses erfindungsgemäßen Verfahrens ist lediglich eine Vorrichtung vonnöten, die in der Zuleitung von einer Ansteuervorrichtung des Leistungs-MOSFETs zur Steuerelektrode dieses Leistungs-MOSFETs angeordnet wird, wobei diese Vorrichtung aus einer für den Einschaltvorgang wirksamen strombegrenzenden Einrichtung und einem elektrischen Schalter, der elektrisch parallel zur Einrichtung geschaltet ist, besteht, wobei einem Steuereingang des Schalters der Potentialverlauf der Steuerelektrode des Leistungshalbleiters zugeführt ist. Diese einfach aufgebaute Vorrichtung, die auch im folgenden als aktiver Gate-Widerstand bezeichnet wird, kann jederzeit ohne großen Aufwand in jede Ansteuervorrichtung eines feldgesteuerten Leistungshalbleiters nachträglich angeordnet werden.

Eine besonders einfache und vorteilhafte Vorrichtung zur Steuerung des Spannungsverlaufes der Steuerspannung eines feldgesteuerten Leistungshalbleiters besteht aus einem Widerstand, der mittels einer elektrisch parallel geschalteten Diode nur während des Einschaltvorgangs des Leistungshalbleiters wirksam ist, wobei dieser Widerstand mittels eines Feldeffekttransistors überbrückt werden kann, wobei deren Steuerelektrode mit einer Hilfsspannungsquelle versehen ist. Bei einem p-Kanal-MOSFET als Schalter ist der zweite Anschluß der Hilfsspannungsquelle mit der Steuerelektrode des Leistungshalbleiters verbunden, wobei bei der Verwendung eines n-Kanal-MOSFET als Schalter dieser zweite Anschluß mit dem Bezugspotential verbunden ist. Durch die Verwendung eines MOSFETs als Schalter beschränkt sich dessen Ansteuerschaltung auf eine Hilfsspannungsquelle, so daß der aktive Gate-Widerstand mit minimalen Bauelementen besonders einfach aufgebaut werden kann.

Zur weiteren Erläuterung wird auf die Zeichnung Bezug genommen, in der mehrere Ausführungsbeispiele des erfindungsgemäßen aktiven Gate-Widerstands schematisch veranschaulicht sind.
Figur 1 zeigt das Prinzipschaltbild einer HF-Speisequelle eines Induktors, die
Figur 2 zeigt einen Teil dieses Prinzipschaltbildes nach

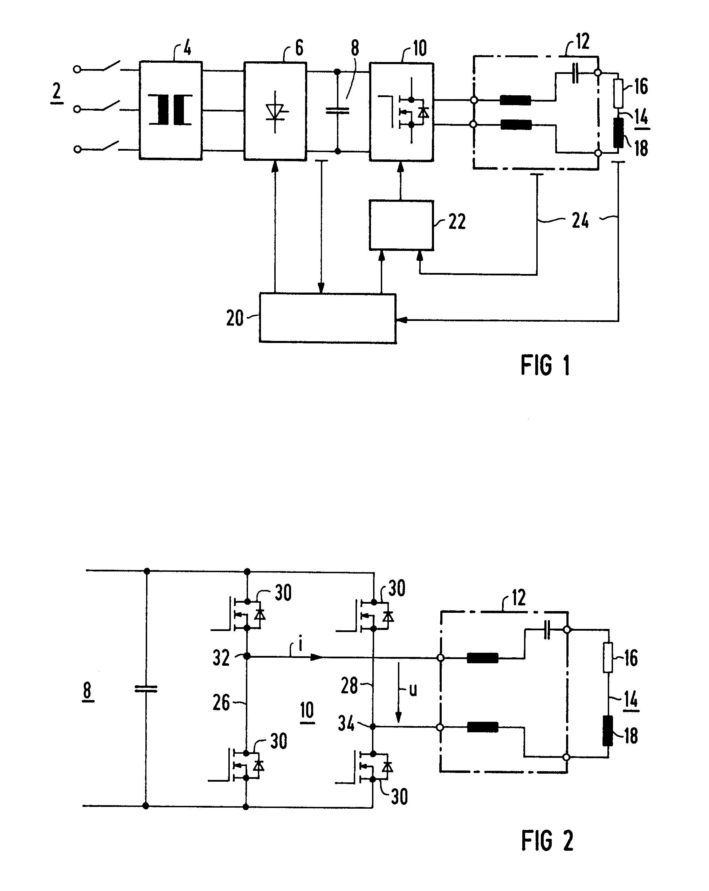

Figur 1 näher, in den

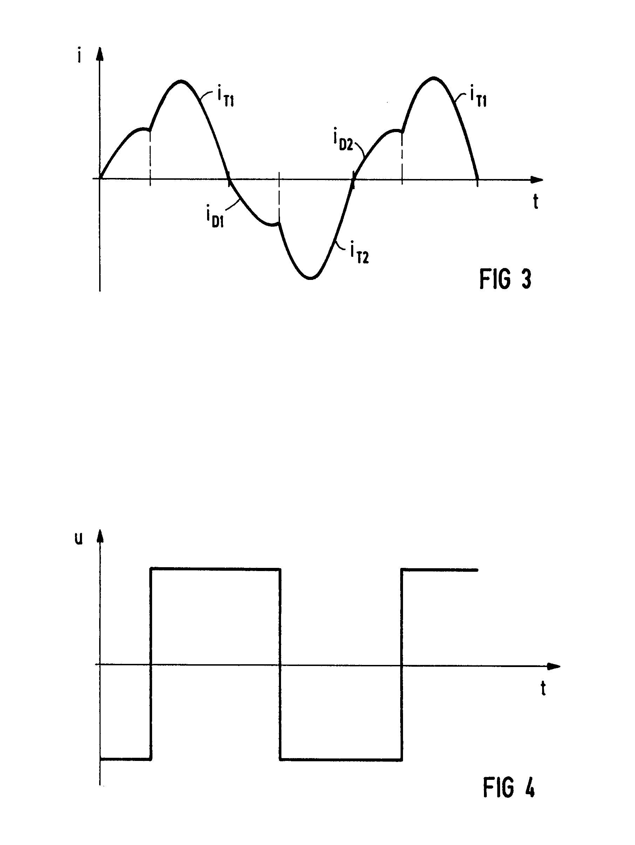

Figuren 3 und 4 sind der Strom und die Spannung eines Induktors im unterresonanten Betrieb jeweils in einem Diagramm über der Zeit t dargestellt und in den

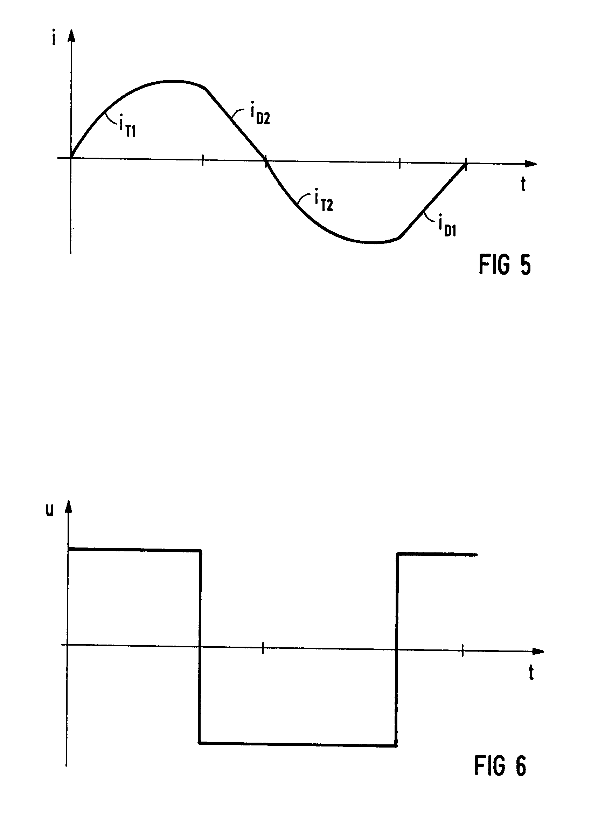

Figuren 5 und 6 sind der Strom und die Spannung eines Induktors im überresonanten Betrieb jeweils in einem Diagramm über der Zeit t dargestellt, die

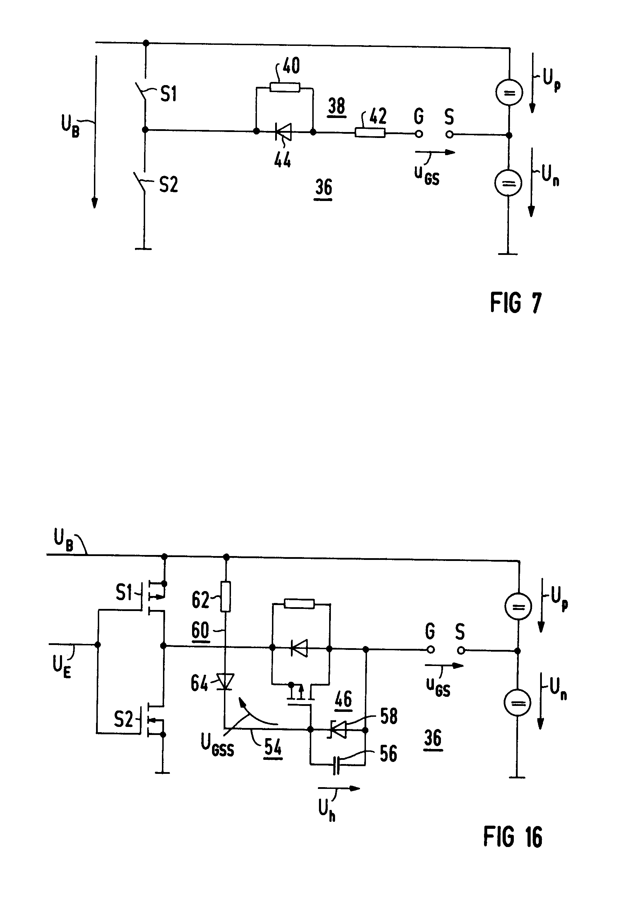

Figur 7 zeigt eine bekannte Ansteuerschaltung für einen feldgesteuerten Leistungshalbleiter, in den

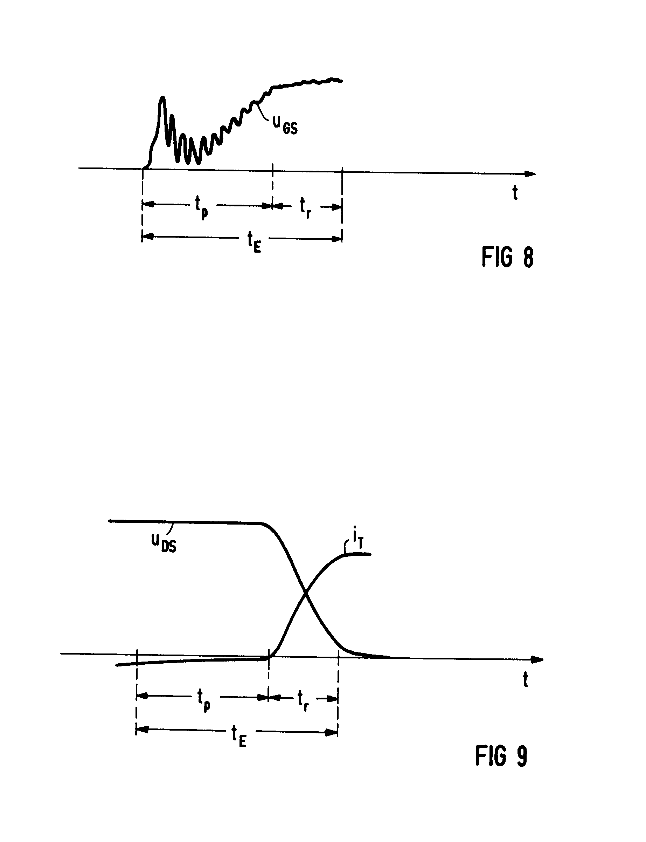

Figuren 8 und 9 sind die zugehörigen Signalverläufe (Steuerspannung U_{GS}, Schalterspannung _{UDS}, Kanalstrom i des Leistungs-MOSFETs) zeitlich dargestellt, die

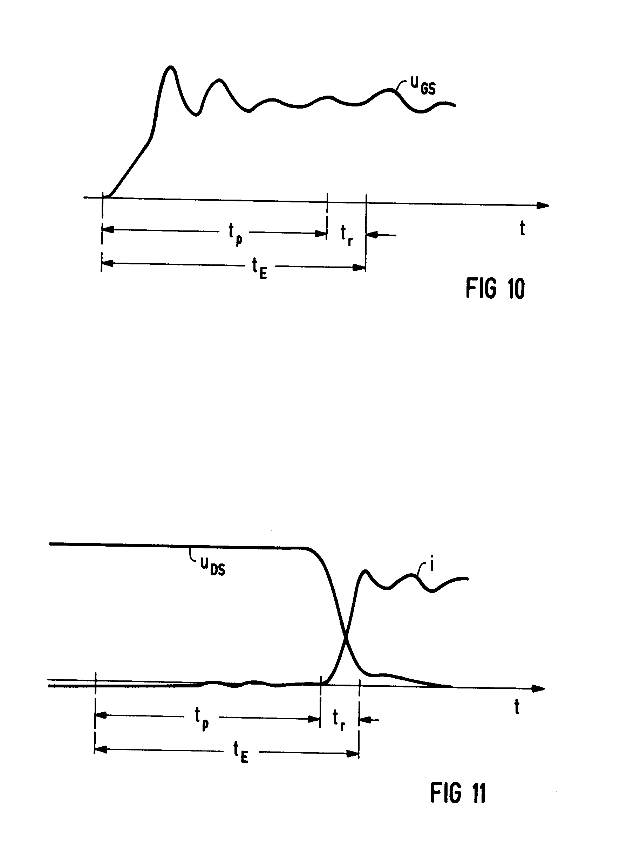

Figuren 10 und 11 zeigen die zeitlichen Signalverläufe (Steuerspannung u_{Gs}, Schalterspannung _{UDS}, Laststrom i des Leistungs-MOSFETs) bei einem sehr kleinen Gate-Widerstand der Ansteuerschaltung eines Leistungshalbleiters, in

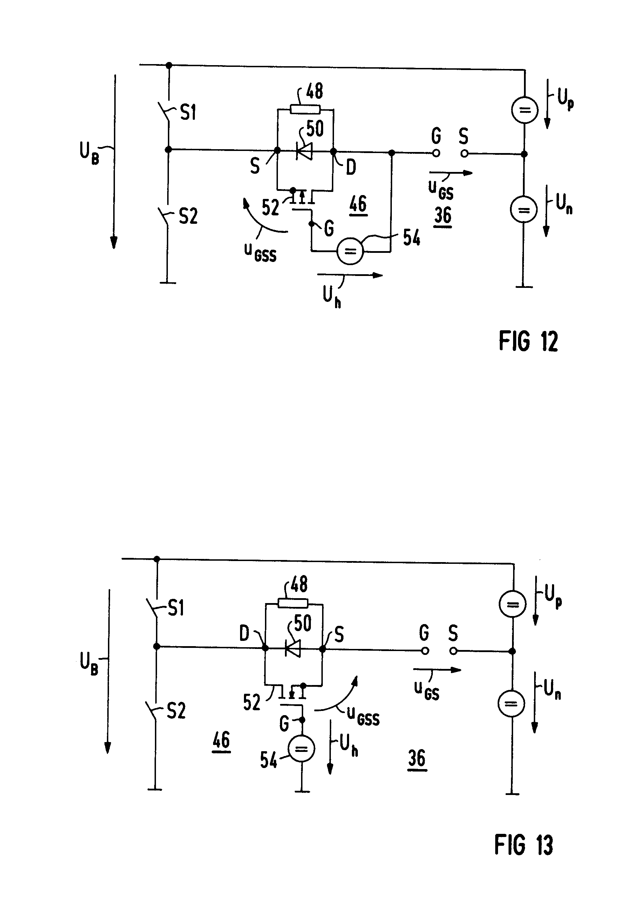

Figur 12 ist eine erste Ausführungsform des erfindungsgemäßen aktiven Gate-Widerstandes und in
Figur 13 ist eine zweite Ausführungsform dieses aktiven Gate-Widerstandes dargestellt, wobei in den

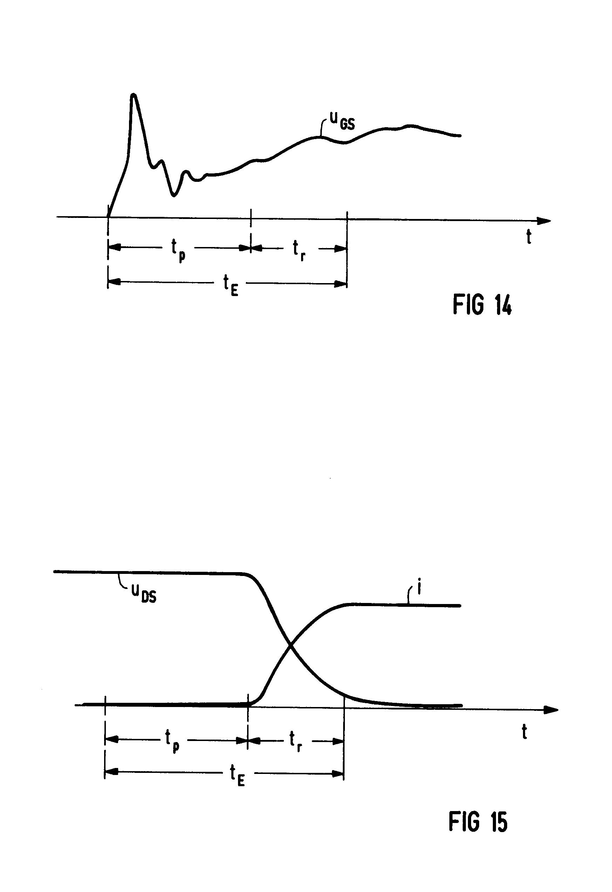

Figuren 14 und 15 die zeitlichen Signalverläufe eines Leistungshalbleiters mit einem aktiven Gate-Widerstand zeitlich dargestellt sind und die
Figur 16 eine schaltungstechnische Realisierung des erfindungsgemäßen aktiven Gate-Widerstan des zeigt.

Wie aus der Figur 1 ersichtlich, wird aus einem Drehstrom netz 2 über einen Transformator 4 und einen steuerbaren Gleichrichter 6 eine Gleichspannung erzeugt, die in der Höhe veränderbar ist. Diese wird im Zwischenkreis 8 geglättet und gepuffert.

Die Gleichspannung wird anschließend durch einen Hochfrequenztransistor-Umrichter 10 in eine pulsförmige Wechselspannung verwandelt und über eine Serienschwingkreis 12 einem Induktor 14 zugeführt, der im Ersatzschaltbild als Widerstand 16 und Induktivität 18 dargestellt ist.

Für den gesteuerten Gleichrichter 6 und den Umrichter 10 sind Regeleinrichtungen 20 und 22 vorgesehen, denen Istwerte 24 aus dem durch Induktor 14 und Serienschwingkreis 12 gebildeten Schwingkreis zugeführt werden. Neben diesen elektrischen Istwerten können auch noch andere Meßgrößen, wie zum Beispiel die Temperatur des Werkstücks usw. für die Regelung herangezogen werden.

Wie der Figur 2 zu entnehmen ist, besteht der Umrichter 10 aus zwei Brückenzweigen 26 und 28, die jeweils in jeder Brückenhälfte einen Leistungs-MOSFET (Metalloxidschicht-Feldeffekttransistor) 30, insbesondere einen selbstsperrenden MOSFET aufweisen. Diese Leistungs-MOSFETs 30 haben jeweils eine interne Diode, auch Inversdiode genannt. An den Ausgangsklemmen 32 und 34 des Hochfrequenz-Umrichters 10 ist die Serienschwingkreis 12 mit ausgangsseitigem Induktor 14 angeschlossen. Der Umrichterausgangsstrom i, auch Induktorstrom genannt, und die Umrichterausgangsspannung u, auch Induktorspannung genannt, sind jeweils in einem Diagramm über der Zeit t für den unterresonanten Betrieb in den Figuren 3 und 4 und für den überresonanten Betrieb in den Figuren 5 und 6 dargestellt.

Im unterresonanten Betrieb liegt eine kapazitive Phase zwischen Umrichterausgangsspannung u und Induktorstrom i vor. Bei dieser kapazitiven Phasenverschiebung endet die Stromleitung mit einem Diodenstrom i_{D1} bzw. i_{D2}. Die Kommutierungsfolge Inversdiode - Transistor ist für diese kapazitive Phasenverschiebung charakteristisch. In dieser Betriebsart müssen die Inversdioden der gegenüberliegenden Leistungs-MOSFETs 30 abkommutiert werden.

In einem Halbbrückenzweig am Spannungszwischenkreis 8 bedeutet das schnelle Schalten auf eine geflutete Diode oft zerstörerische Überspannungen an den Leistungshalbleitern, hervorgerufen durch den Diodenabriß der abkommutierten Diode und den parasitären Anschlußinduktivitäten des Leistungshalbleiters. Durch diesen Sachverhalt werden insbesondere Leistungs-MOSFETs in ihrem Betriebsbereich erheblich eingeschränkt, da die interne Diode auch bei FREDFETs halbleitertechnologisch ein schlechtes Abrißverhalten zeigt. Wie bereits eingangs erwähnt, hat selbst kurzzeitiges Überschreiten der höchstzulässigen Drain/Source-Spannung für 1 bis 2 ns den Ausfall des Bauelementes zur Folge.

Im überresonanten Betrieb liegt eine induktive Phase zwischen Umrichterausgangsspannung u und Induktorstrom i vor. Bei dieser induktiven Phasenverschiebung beginnt die Stromleitung mit einem Diodenstrom i_{D1} bzw. i_{D2}. Die Kommutierungsfolge Inversdiode - zugehöriger Transistor ist für diese induktive Phasenverschiebung charakteristisch. In dieser Betriebsart kommutiert der Strom von einer Inversdiode auf den zugehörigen Transistor, wodurch ein Diodenabriß mit seinen Folgen nicht mehr auftritt.

Wie aus den eingangs genannten Aufsätzen bekannt ist, kann es zu einem mehr oder weniger häufigen Induktorversagen kommen, wobei dieser unvermeidbare Havariefall sich in Bezug auf die Energiequelle als Lastkurzschluß oder als Lastabwurf darstellt. In einem solchen Havariefall treten Schwankungen in der Resonanzfrequenz auf, die sich kurzzeitig in einer kapazitiven Phasenverschiebung äußern. Das heißt, der überresonante Betrieb kann im Havariefall kurzzeitig in den unterresonanten Betrieb wechseln, wobei das Problem des schnellen Schaltens auf eine geflutete Diode auftritt. Da die Zeit für das Erkennen von Havariefällen und Aktivieren von Schutzmaßnahmen sehr kurz ist, sind die Chancen für das Einleiten von Gegenmaßnahmen bei Hochfrequenz-Umrichtern mit einer Arbeitsfrequenz von über 200 kHz fast unmöglich.

Die Figur 7 zeigt eine bekannte Ansteuerschaltung 36, die aus einer Gegentakt-Schaltstufe, bestehend aus zwei Schaltern S1 und S2, zwei Gleichspannungsquellen Up und Uₙ und einem Gate-Widerstand 38 besteht. Die Ausgangsklemmen G und S dieser Ansteuerschaltung 36 sind mit der Steuerelektrode G und der Sourceelektrode S des Leistungs-MOSFETs elektrisch leitend verbunden. Mittels des Schalters S1 wird die Gleichspannungsquelle Up über den Gate-Widerstand 38 an die Gate-Source-Strecke eines Leistungs-MOSFETs und mittels des Schalters S2 wird die Gleichspannungsquelle Uₙ über den Gate-Widerstand 38 an die Source-Gate-Strecke eines Leistungs-MOSFETs gelegt. Der Gate-Widerstand 38 besteht aus zwei Widerständen 40 und 42, deren Widerstandswerte sehr unterschiedlich hoch sind. Dem Widerstand 40 mit dem größeren Widerstandswert ist eine Diode 44 derart elektrisch parallel geschaltet, daß dieser Widerstand 40 überbrückt wird, sobald die Gleichspannungsquelle mittels des Schalter S2 an die Source-Gate-Strecke eines Leistungs-MOSFETs gelegt wird (Aussschaltvorgang). Durch diesen Gate-Widerstand 38 wird während des Einschaltvorgangs das Gate des Leistungs-MOSFETs langsamer geladen, wodurch der Drain-Source-Kanal dieses Leistungs-MOSFET auch langsamer durchschaltet. Dadurch wird im Havariefall auch der Diodenabriß gemildert.

In der Figur 8 ist die Steuerspannung u_{Gs} der bekannten Ansteuerschaltung 36 nach Figur 7 zeitlich dargestellt. In Figur 9 sind die Drain-Source-Spannung U_{DS} des Leistungs-MOSFETs und der Induktorstrom i für den Einschaltvorgang t_{E} zeitlich dargestellt. Der Einschaltvorgang t_{E} setzt sich zusammen aus einer Ansteuertotzeit tp, auch "propagation delay" genannt, und einer Anstiegszeit t" auch "rise time" genannt, zusammen. Durch die Vergrößerung des Wertes des Gate-Widerstandes 38 wird nicht nur die propagation delay tp,sondern auch die rise time tᵣ vergrößert. Dadurch wird im Havariefall der Diodenabriß beherrschbar, jedoch soll die rise time tᵣ des Leistungs-MOSFETs einen vorbestimmten Wert haben, der auf das Verhalten der Diode zugeschnitten ist.

In den Figuren 10 und 11 sind dieselben Signalverläufe wie in den Figuren 8 und 9 zeitlich dargestellt, wobei der Wert des Gate-Widerstandes 38 um den Faktor 10 kleiner ist. Bei einem Widerstandswert von 4,7 Ω erhält man gemäß den Figuren 8 und 9 eine propagation delay tp = 146 ns und eine rise time tᵣ = 80 ns. Soll jedoch in beiden Fällen beispielsweise die rise time tᵣ den Wert 40 ns nicht überschreiten, so wird bei der herkömmlichen Schaltung ein Widerstandswert von nur 2,5 Q benötigt. Mittels diesem Widerstandswert erhält man eine propagation delay tp = 90 ns. Bei einem Widerstandswert von 0,47 Q (minimaler Gatewiderstandswert eines Leistungs-MOSFETs) erhält man gemäß den Figuren 10 und 11 eine propagation delay tp = 50 ns und eine rise time tᵣ = 8 ns. Leistungs-MOSFETs 30, die jeweils mit einer Ansteuereinrichtung 36 verknüpft werden, die einen Gate-Widerstand 42 mit einem Wert von 0,47 Q aufweist, werden im Havariefall zerstört werden.

In Figur 12 ist eine erste Ausführungsform eines erfindungsgemäßen aktiven Gate-Widerstandes 46 näher dargestellt. Dieser aktive Gate-Widerstand 46 besteht aus einem Widerstand 48, einer Diode 50 und einem Schalter 52. Die Diode 50 ist derart elektrisch parallel zum Widerstand 48 geschaltet, daß dieser Widerstand 48 nur beim Einschaltvorgang t_{E} wirksam ist. Diese Parallelschaltung kann mittels des Schalters 52 kurzgeschlossen werden. Als Schalter 52 ist ein p-Kanal-Enhancement-MOSFET vorgesehen, der bei einer Gate-Source-Spannung U_{GSS} gleich Null sperrt. Bei der Verwendung eines MOSFET als Schalter 52 wird die Diode 50 nicht mehr benötigt, da der MOSFET bereits eine Inversdiode enthält. Der Drain-Anschluß D des Schalters 52 ist mit dem Arischluß G der Ansteuervorrichtung 36 und dessen Source-Anschluß S ist mit einem Verbindungspunkt der beiden Schalter S1 und S2 der Gegentaktstufe verknüpft. Der Gate-Anschluß G dieses p-Kanal-MOSFETs 52 ist mittels einer Hilfsspannungsquelle 54 mit dem Anschluß G der Ansteuervorrichtung 36 verbunden. Als Diode 50 wird vorzugweise eine Schotkey-Diode verwendet, die auch dann verwendet wird, wenn der Schalter 52 eine Inversdiode aufweist. Dadurch wird das Ausschaltverhalten der Inversdiode des Schalters 52 wesentlich verbessert.

Ist der Schalter S2 geschlossen, so sperrt der Schalter 52, da seine Gate-Source-Spannung U_{GSS} gleich der Spannung Uₕ der Hilfsspannungsquelle 54 ist. Schaltet der Schalter S1 ein, so schaltet der Schalter S2 aus, wodurch der Source-Anschluß S des Schalters 52 mittels einer Spannung U_{B} beaufschlagt wird, die gleich der Summe der Spannungen der Gleichspannungsquellen Up und Uₙ ist. Da in diesem Schaltaugenblick die Steuerspannung U_{GS} am Ausgang der Ansteuervorrichtung 36 gleich der negativen Spannung der Spannungsquelle Uₙ ist, ist die Gate-Source-Spannung U_{GSS} des Schalters 52 sehr viel negativer als seine Schwellspannung und der Schalter 52 ist somit eingeschaltet, wodurch der Widerstand 48 kurzgeschlossen ist. Dadurch wird das Gate eines Leistungs-MOSFETs sehr schnell aufgeladen und seine Steuerspannung uαε steigt an (Figur 14) und verschiebt dabei das über der Hilfsspannungsquelle 54 angebundene Potential am Gate G des Schalters 52 in Richtung des Spannungswertes U_{B}.Unterschreitet die Gate- Source-Spannung U_{GSS} des Schalters 52 seine Schwellspannung, so sperrt der Schalter 52, erkennbar am Abstieg des Steuerspannungssignals U_{GS} gemäß Figur 14, und das Gate eines Leistungs-MOSFETs wird nur noch über den Widerstand 48 aufgeladen. Dadurch steigt die Steuerspannung u_{Gs} gemäß Figur 14 mit einer viel geringeren Steigung dur/dt an. Der Anstieg dup/dt am Anfang des Einschaltvorgangs t_{E} ist aber sehr viel größer als der Anstieg dur/dt während der überwiegenden Zeit des Einschaltvorgangs t_{E}.

Wählt man als widerstandswert des Widerstands 48 den Wert 4,7 Q, so erhält man mit dieser erfindungsgemäßen Vorrichtung zur Steuerung des Spannungsverlaufs der Steuerspannung u_{Gs} eines Leistungs-MOSFETs während des Einschaltvorgangs t_{E} eine propagation delay tp = 70 ns und eine rise time tᵣ = 40 ns. Diese Werte sind wesentlich kleiner als die Werte mit der bekannten Ansteuervorrichtung 36 nach Figur 7.

Mittels des aktiven Gate-Widerstands 46 wird im Havariefall der Diodenabriß automatisch beherrscht, so daß keine unzulässig hohe Drain-Source-Spannung auftritt, und im Normalbetrieb die Einschaltzeit nicht unnötig verlängert wird.

In der Figur 13 ist eine weitere Ausführungsform des aktiven Gate-Widerstands 46 dargestellt. In dieser Ausführungsform ist als Schalter 52 ein n-Kanal-Enhancement-MOSFET vorgesehen. Dadurch ist die Hilfsspannungsquelle 54 mit seinem zweiten Anschluß nicht mit dem Ausgang G der Ansteuereinrichtung 36 verbunden, sondern mit dem Massepotential. Der Drain-Anschluß D des Schalters 52 ist bei dieser Ausführungsform mit dem Verbindungspunkt der beiden Schalter S1 und S2 der Gegentaktstufe der Ansteuervorrichtung 36 und der Source-Anschluß S des Schalters 52 ist mit dem einen Ausgang G der Ansteuervorrichtung 36 verbunden. Somit führt diese zweite Ausführungsform des aktiven Gate-Widerstands 46 dasselbe Verfahren durch wie die erste Ausführungsform gemäß Figur 12.

In Figur 16 ist eine realisierte Ansteuereinrichtung 36 mit dem erfindungsgemäßen aktiven Gate-Widerstand 46 näher dargestellt. Als Schalter S1 ist ein p-Kanal-MOSFET und als Schalter S2 ist ein n-Kanal-MOSFET vorgesehen. An beiden Gates dieser MOSFETs ist ein Eingangssignal U_{E} angelegt. Als Hilfsspannungsquelle 54 ist ein Kondensator 56 vorgesehen, dem eine Zenerdiode 58 elektrisch parallel geschaltet ist. Der Kondensator 56 ist mit einem Anschluß mittels einer Reihenschaltung 60, die aus einem Strombegrenzungswiderstand 62 und einer Entkopplungsdiode 64 besteht, auf die Spannung U_{B} gelegt. Über diese Reihenschaltung 60 wird der Kondensator 56 so lange aufgeladen bis die Zenerspannung der Zenerdiode 58, beispielsweise Uₕ, erreicht ist.

Mit diesem erfindungsgemäßen aktiven Gate-Widerstand 46 wird im Falle eines Induktorversagens der Diodenabriß einer abkommutierenden Diode automatisch gemildert, so daß der Schaden auf den zerstörten Induktor beschränkt bleibt. Somit hat man mit dem aktiven Gate-Widerstand 46 für jeden feldgesteuerten abschaltbaren Leistungshalbleiter 30 des Hochfrequenz-Umrichters 10 der Hochfrequenzenergiequelle eine havariefeste Energiequelle, das ein wichtiges Kriterium für das Induktionshärten ist.

## Patentansprüche

1. Verfahren zur Steuerung des Spannungsverlaufes der Steuerspannung (u_{Gs}) während eines Einschaltvorgangs (t_{E}) eines mittels eines elektrischen Feldes gesteuerten abschaltbaren Leistungshalbleiters (30) in Abhängigkeit des Potentialverlaufs an seiner Steuerelektrode (G), wobei zu Beginn der Ansteuertotzeit (tp) dieses Einschaltvorgangs (t_{E}) der Anstieg (dup/dt) der Steuerspannung (u_{Gs}) gegenüber dem Anstieg (dur/dt) während der Anstiegszeit (t,) dieses Einschaltvorgangs (t_{E}) sehr viel größer ist und wobei in Abhängigkeit des Potentialverlaufs an der Steuerelektrode (G) des Leistungshalbleiter (30) zwischen diesen beiden Anstiegen (dup/dt, dur/dt), gesteuert umgeschaltet wird.

2. Vorrichtung (46) zur Durchführung des Verfahrens nach Anspruch 1, bestehend aus einer für den Einschaltvorgang (t_{E}) wirksamen strombegrenzenden Einrichtung und einem elektrischen Schalter (52), der elektrisch parallel zu dieser Einrichtung geschaltet ist, wobei einem Steuereingang des Schalters (52) der Potentialverlauf der Steuerelektrode (G) eines abschaltbaren Leistungshalbleiters (30) zugeführt ist.

3. Vorrichtung (46) nach Anspruch 2, wobei die strombegrenzende Einrichtung aus einer Parallelschaltung eines Widerstandes (48) und einer Diode (50) besteht, die in Sperrichtung zum Einschaltstrom des Leistungshalbleiters (30) geschaltet ist.

4. Vorrichtung (46) nach Anspruch 2, wobei als elektrischer Schalter (52) ein Bipolartransistor vorgesehen ist.

5. Vorrichtung (46) nach Anspruch 2, wobei als elektrischer Schalter (52) ein Feldeffekttransistor vorgesehen ist.

6. Vorrichtung (46) nach Anspruch 5, wobei als Feldeffekttransistor (52) ein selbstsperrender p-Kanal-Metalloxidschicht-Feldeffekttransistor vorgesehen ist, dessen Steuerelektrode (G) mit einer Hilfsspannungsquelle (54) versehen ist, die eingangsseitig mit der Steuerelektrode (G) des Leistungshalbleiters (30) elektrisch leitend verbunden ist.

7. Vorrichtung (46) nach Anspruch 5, wobei als Feldeffekttransistor (52) ein selbstsperrender n-Kanal-Metalloxidschicht-Feldeffekttransistor vorgesehen ist, dessen Steuerelektrode (G) mit einer Hilfsspannungsquelle (54) versehen ist, die eingangsseitig mit Erdpotential elektrisch leitend verbunden ist.

8. Vorrichtung (46) nach Anspruch 5, wobei als Hilfsspannungsquelle (54) ein Kondensator (56) mit paralleler Zenerdiode (58) vorgesehen ist, wobei der Kondensator (56) mittels eines strombegrenzenden Widerstandes (62) und einer Entkopplungsdiode 64 mit einer Spannungsversorgung (U_{B}) der Ansteuervorrichtung (36) elektrisch leitend verbunden ist.

9. Vorrichtung (46) nach Anspruch 2, wobei diese Vorrichtung (46) in der Zuleitung von einer Ansteuervorrichtung (36) zur Steuerelektrode (G) eines abschaltbaren Leistungshalbleiters (30) angeordnet ist.

10. Vorrichtung (46) nach Anspruch 2, wobei diese Vorrichtung (46) Bestandteil einer Ansteuerung (36) eines abschaltbaren Leistungshalbleiters (30) ist.
